# EUROPÄISCHE PATENTSCHRIFT

(11) **EP 2 549 529 B1**
(45) Veröffentlichungstag und Bekanntmachung des Hinweises auf die Patenterteilung: **15.02.2017**
(21) Anmeldenummer: 11010292.8
(22) Anmeldetag: 29.12.2011
(51) Int. Cl.: H01L 23/16, H01L 23/31

(54) **Halbleitergehäuse und Verfahren zur Herstellung eines Halbleitergehäuses**
Semiconductor housing and method for manufacturing same
Boîtier semi-conducteur et procédé de fabrication d'un boîtier semi-conducteur

(30) Priorität: 09.03.2011 DE 102011013468
(43) Veröffentlichungstag der Anmeldung: 23.01.2013
(73) Patentinhaber: Micronas GmbH, 79108 Freiburg (DE)
(72) Erfinder: Kolleth, Tobias, 79108 Freiburg (DE); Joos, Christian, 79238 Ehrenkirchen (DE); Stumpf, Pascal, 68180 Horbourg-Wihr (DE)
(74) Vertreter: Koch Müller Patentanwaltsgesellschaft mbH

(56) Entgegenhaltungen:
- EP-A1- 2 154 713
- WO-A1-2006/101274
- WO-A1-2006/114005
- DE-A1-102008 039 068
- US-A- 4 894 707
- US-A1- 2009 243 015
- US-B1- 6 401 545

## Beschreibung

Die Erfindung betrifft ein Halbleitergehäuse und ein Verfahren zur Herstellung eines Halbleitergehäuses gemäß dem Oberbegriff des Patentanspruchs 1 und dem Oberbegriff des Patentanspruchs 15.

Ein Halbleitergehäuse ist im Stand der Technik beispielsweise aus der US2009/0243015 bekannt.
Aus der "Fabrication and Performance of MEMS-Based Pressure Sensor Packages Using Patterned Ultra-Thlck Photoreslsts", Sensors 2009, 9, 6200 - 6218, ist ein Halbleitergehäuse, auch Chipgehäuse genannt, und ein Verfahren zur Herstellung eines solchen bekannt. Derartige Gehäuse werden unter anderem zur Aufnahme von Sensoren verwendet. Hierzu weisen die Gehäuse an ihrer Oberseite eine Öffnung auf. Mittels der Öffnung können die Sensoren an der Oberseite des ansonsten mit einer Vergussmasse umspritzten Halbleiterkörpers mit der Umgebung kommunizieren. Im Fall von Gassensoren können beispielsweise Gasmoleküle durch die Öffnung zum Sensor diffundieren. Bei der Herstellung derartiger Gehäuse ist es wichtig, während des Moldprozesses einerseits sicherzustellen, dass keine Moldmasse in den Bereich der Öffnung vordringt, andererseits insbesondere die Bonddrähte und den Nichtsensorbereich, welcher im Allgemeinen einen Schaltungsteil umfasst, mit Moldmasse abzudecken, um diese Bereiche zuverlässig vor Umgebungseinflüssen zu schützen. In dem oben genannten Stand der Technik wird hierzu vorzugsweise am Ende des Halbleiterherstellungsprozesses mittels eines Lithographieprozesses auf die Oberfläche des Halbleiterkörpers ein geschlossener Wall errichtet. Der Wall wird dann gegen die Innenseite des Moldwerkzeugs, in der ein sogenannter "Transfer Moldprozess" durchgeführt wird, gedrückt und die Moldmasse bis zur Höhe des Walls auf den Halbleiterkörper eingebracht. Um die Bonddrähte und andere Aufbauten auf der Oberseite mit einer Kunststoffmasse zu umspritzen, ist erforderlich den Wall sehr hoch auszuführen. Des Weiteren darf die Höhenschwankung von Wall zu Wall nur sehr klein sein, um beim Anpressen des Halbleiterkörpers an die Innenseite der Transferkammer den Wall aufgrund des hohen Anpressdruckes nicht zu beschädigen.

Eine andere Möglichkeit in einem Halbleitergehäuse Öffnungen herzustellen, ist in der EP 0 202 701 B1 offenbart. Hierbei werden die Öffnungen ohne die Ausbildung von Wällen mittels eines konventionellen stempelführenden Spritzwerkzeuges ausgebildet. Der Stempel muss hierbei mit einer relativ kostenintensiven Folie ummantelt werden. Anschließend wird der Stempel bis auf die Oberfläche des Halbleiterkörpers abgesenkt. Die elastische Folie soll unter anderem eine Beschädigung der Halbleiteroberfläche verhindern.

Aus der WO 2006 / 114005 A1 ist eine weiteres Verfahren zur Herstellung eines Halbleitergehäuse mit einer Öffnung offenbart. Hierbei wird vor der Herstellung des Kunststoffgehäuses ein eine Sensorfläche überlappenden Wall ausgebildet, der gegen Ende des Herstellungsprozesses vorzugsweise nasschemisch entfernt wird.

Vor diesem Hintergrund besteht die Aufgabe der Erfindung darin, eine Vorrichtung und ein Verfahren anzugeben, die den Stand der Technik weiterbilden.

Die Aufgabe wird durch Halbleitergehäuse mit den Merkmalen des Patentanspruchs 1 und durch ein Verfahren gemäß dem Patentanspruch 15 zur Herstellung eines Halbleitergehäuses gelöst. Vorteilhafte Ausgestaltungen der Erfindung sind Gegenstand von Unteransprüchen.

Gemäß dem ersten Gegenstand der Erfindung wird ein Halbleitergehäuse offenbart, aufweisend, einen Metallträger, einen auf dem Metallträger angeordneten Halbleiterkörper mit einer Oberseite und einer Unterseite, wobei die Unterseite mit dem Metallträger kraftschlüssig verbunden ist, und der Halbleiterkörper auf der Oberseite mehrere Metallflächen aufweist, und die Metallflächen zur elektrischen Kontaktierung des Halbleiterkörpers mittels Bonddrähten mit Pins verbunden sind, und eine Kunststoffmasse, wobei die Kunststoffmasse die Bonddrähte vollständig und den Halbleiterkörper an dessen Oberseite sowie die Pins teilweise umschließt, und wobei die Kunststoffmasse an der Oberseite des Halbleiterkörpers eine Öffnung aufweist, und ein rahmenförmiger oder ringförmiger Wall auf der Oberseite des Halbleiterkörpers ausgebildet ist, wobei der Wall eine Deckfläche und eine von den Rändern des Halbleiterkörpers beanstandete Grundfläche aufweist und die lichten Innenmaße des Walls die Größe der Öffnung auf der Oberseite des Halbleiterkörpers bestimmt, und wobei in Richtung des Normalenvektors der Fläche auf der Oberseite des Halbleiterkörpers die Kunststoffmasse im Bereich außerhalb der Öffnung im Wesentlichen eine größere Höhe als der Wall aufweist und zwischen der Grundfläche des Walls und der Oberseite des Halbleiterkörpers eine Fixierschicht ausgebildet ist und der Wall von einer innerhalb der Öffnung ausgebildeten Sensorfläche beabstandet ist.

Gemäß dem zweiten Gegenstand der Erfindung wird ein Verfahren zur Herstellung eines Halbleitergehäuses mit einer Öffnung offenbart, wobei in einem Prozessschritt ein Wafer in Halbleiterkörper vereinzelt wird, und der Halbleiterkörper, der eine Oberseite und eine Unterseite aufweist, mit seiner Unterseite auf einen Metallträger befestigt wird, und der Halbleiterkörper mit Pins in einem Bondprozess über Bonddrähte elektrisch verbunden wird, sowie in einem nachfolgenden Prozessschritt ein rahmenförmiger Wall auf der Oberfläche des Halbleiterkörper fixiert wird, und in einem anschließenden Moldprozess ein Stempel, der eine Oberfläche aufweist, und die Oberfläche des Stempels wenigstens teilweise auf die Deckfläche des Walls gedrückt wird und anschließend eine Kunststoffmasse, auch Vergussmasse genannt, eingespritzt und ausgehärtet wird, so dass die Bonddrähte vollständig und der Halbleiterkörper auf dessen Oberfläche und vorzugsweise auch an dessen Seitenflächen und die Pins teilweise von der Kunststoffmasse umschlossen werden.

Ein Vorteil der erfindungsgemäßen Vorrichtung und des Verfahrens ist es, dass sich Öffnungen in einem Halbleitergehäuse zuverlässig und kostengünstig herstellen lassen. Hierzu wird nach dem Vereinzeln des Wafers in einzelne Halbleiterkörper und dem Anordnen eines einzelnen Halbleiterkörpers, auch Die genannt, der Halbleiterkörper mit der Unterseite auf die Oberseite eines Metallträgers, dem sogenannten Leadframe, kraftschlüssig verbunden. In dem anschließenden Bondprozess werden Bonddrähte von den Metallflächen zu den Pins gezogen und mittels eines Standardbondverfahrens befestigt, um eine elektrische Verbindung zwischen den Metallflächen und den Pins auszubilden. Anschließend wird der rahmenförmige oder ringförmige Wall, der an der Unterseite eine Fixierschicht enthält, mit der Unterseite auf der Oberfläche eines jeden Halbleiterkörper fixiert, um in dem darauffolgenden Prozessschritten eine Öffnung auszubilden. Mittels des Aufsetzens eines fertigen Rahmens auf den Halbleiterkörper lässt sich ein aufwändiger Lithographieprozess zur Ausbildung eines Walls vermeiden. Ein weiterer Vorteil ist, dass mittels des Rahmens sich einerseits nahezu beliebige Höhen des Walls einstellen lassen und andererseits Toleranzen, insbesondere die Höhentoleranzen, des Walls reduzieren lassen. Indem der Wall von einer innenliegenden Sensorfläche beabstandet ist, lässt sich der Herstellungsprozess insbesondere für Halbleiterkörper welche insbesondere eine Sensorfläche aufweisen, ausbilden, ohne dass eine Gefahr der Beschädigung der Sensorfläche besteht. Es ist bevorzugt, die Unterseite des Walls vollflächig ohne Ausbildung einer Stufe auf der Fixierschicht anzuordnen und auch die Fixierschicht vollflächig, d. h. ohne Ausbildung einer Stufe, auf der Oberfläche des Halbleiterkörpers auszubilden.

Gemäß einer Weiterbildung ist die Fixierschicht als ein umlaufend geschlossener Streifen ausgebildet. Hierbei ist die Fixierschicht vorzugsweise als eine streifenförmige Klebeschicht oder als eine Trägerschicht mit doppelseitig klebenden Eigenschaften ausgebildet. In einer alternativen Ausführungsform ist die Fixierschicht als Kunststofffolie, insbesondere als Kaptonfolie, mit einer oberseitigen und einer unterseitigen Klebeschicht ausgebildet. Vorzugsweise ist die Dicke der Kaptonfolie im Wesentlichen so groß wie die Dicken der oberseitigen und unterseitigen Klebeschicht zusammen. Mittels der Fixierschicht wird der Wall gegen ein Verrutschen in den weiteren Prozessschritten gesichert. Des Weiteren wird eine zuverlässige Dichtfläche zwischen der Unterseite des Walls und der Halbleiteroberfläche bei der Ausbildung des Halbleitergehäuses ausgebildet. Anschließend drückt ein Stempel auf die Deckfläche des Walls und der Halbleiterkörper wird mit einer Kunststoffmasse vergossen. Der Prozess des Vergießens mit der Kunststoffmasse wird auch als Molden bezeichnet. Ferner lassen sich bei Verwendung einer elastischen Fixierschicht die Druckkräfte des Stempels bei dem Moldprozess wenigstens teilweise aufnehmen und eine Beschädigung der unterliegenden Halbleiteroberfläche reduzieren.

Untersuchungen haben gezeigt, dass insbesondere mittels des Aufsetzens eines vorgefertigten Walls, der vorzugsweise als Rahmen ausgebildet ist, eine Herstellung eines Rahmens wesentlich zuverlässiger und kostengünstiger ausführbar ist. Insbesondere weisen niedrigere Rahmen eine geringere Höhentoleranz auf. Hierbei ist es bevorzugt, dass der Wall eine Höhe von mindestens 100 µm, höchst vorzugsweise eine Höhe von wenigstens 250 µm und maximal eine Höhe von 1 mm aufweist. Insbesondere bei einem nachfolgenden Moldprozess ist ein niedriger Wall von erheblichem Vorteil, da die Reproduzierbarkeit der Druckbelastung der auf die Deckfläche des Walls aufliegenden Stempeloberfläche wesentlich höher ist. Hierdurch werden einzelne Wälle übermäßig belastet. Es sei angemerkt, dass sich der Wall neben kreisförmig und rahmenförmig auch mäanderförmig ausbilden lässt.

Mit der lichten Weite des Walls, d.h. bei einer ringförmigen Ausprägung dem inneren Durchmesser, wird die Größe der Öffnung auf der Oberseite des Halblelterkörpers bestimmt. Es ist bevorzugt, den rahmenförmigen Wall aus einem Metall, welches vorzugsweise Kupfer enthält, auszubilden. Ein Vorteil des Metallrahmens ist die chemische und insbesondere hohe mechanische Stabilität. Hierdurch wird die Zuverlässigkeit bei der Ausbildung des Gehäuses während des Moldprozesses erhöht.

In einer anderen Weiterbildung weist der Wall an wenigstens einer Außenseite einen Steg auf. Insbesondere ist es bevorzugt, dass der Wall genau vier Stege aufweist. Des Weiteren ist es bevorzugt, dass die Stege an der Außenseite des Halbleitergehäuses teilweise sichtbar sind.

Insbesondere lassen sich Halbleitergehäuse mit Öffnungen für die Herstellung bzw. Integration von integrierten Sensoren in Halbleiterchips einsetzen.

Hierbei wird das Sensorelement an dem unteren Ende der Öffnung auf der Oberfläche des Halbleiterkörpers angeordnet oder in dessen Oberfläche wenigstens teilweise integriert. Der elektrische Anschluss der Sensoren wird zweckmäßigerweise mittels Leiterbahnen durchgeführt. Der Halbleiterkörper, auch Chip genannt, weist auf seiner Oberseite Metallflächen, auch als Pads bezeichnet, zum Anschluss des Chips an Pins mittels von Bonddrähten auf.

Untersuchungen der Anmelderin haben gezeigt, dass sich in einer Weiterbildung die Verwendung einer kostenintensiven Folie auf der Oberfläche des Stempelwerkzeuges erübrigt. Hierdurch wird während des Moldprozesses die Oberfläche des Stempels unmittelbar auf die Deckfläche des Walls gedrückt.

Gemäß einer anderen Weiterbildung ist die Deckfläche des Walls wenigstens teilweise parallel zu der Oberfläche des Halbleiterkörpers ausgebildet. Vorzugsweise wird zumindest von einem Teil der Oberfläche des Stempels auf der gesamten Länge des Walls wenigstens ein Teil der Deckfläche des Walls formschlüssig abgeschlossen. Hierdurch bildet sich während des Moldprozesses eine dichtende Fläche zwischen Deckfläche des Walls und der Oberfläche des Stempels aus. Des Weiteren ist es vorteilhaft, wenn der Querschnitt des Walls einen im Wesentlichen rechteckigen Querschnitt aufweist. Hierdurch weist der Wall eine geringe Ausdehnung an der Unterseite auf und lässt sich insbesondere nahe an eine integrierte Schaltung positionieren. Gemäß einer anderen Ausführungsform ist der Wall auf der Oberfläche des Halbleiterkörpers umlaufend vollständig geschlossen ausgebildet.

In der bevorzugten Ausführungsform sind die Außenseiten des Walls von dem Rand des Halbleiterkörpers beabstandet. Hierbei werden die Größe und der Abstand so gewählt, dass sich innerhalb des Walls ein oder mehrere Sensoren ausbilden lassen und in dem Bereich zwischen Außenseite des Walls und dem Rand des Halbleiterkörpers die Bondflächen und Schaltungsteile anordenbar sind.

Des Weiteren ist es bevorzugt, den Stempel derart auf die Deckfläche zu positionieren, dass die Kunststoffmasse formschlüssig mit dem Wall, vorzugsweise entlang der gesamten von der Öffnung abgewandeten Seitenfläche des Walls, verbunden ist. Des Weiteren ist es vorteilhaft, wenn der Öffnungswinkel der Öffnung, d.h. der Winkel der Normalen der Oberfläche des Halbleiterkörpers größer 0°, vorzugsweise 7° bis 10°, beträgt. Hierdurch wird der Durchmesser oder die Lichte Weite der Öffnung zur Oberseite des Halbleitergehäuses vergrößert. Insbesondere für eine Einstrahlung von Licht und / oder eine Eindiffusion von Gasmolekülen für ein innerhalb der Öffnung ausgebildeten Sensor ist dies vorteilhaft.

Gemäß einer Weiterbildung bilden die Kunststoffmasse und Deckfläche einen Absatz aus, so dass wenigstens ein Teil der Deckfläche des Walls nicht mit Kunststoffmasse bedeckt ist. Die minimale Größe des Absatzes ergibt sich aus Mindestauflagefläche des Stempels auf der Deckfläche des Walls.

In einer besonders bevorzugten Ausführungsform ist auf der Deckfläche des Walls eine Platte ausgebildet, wobei die Platte die Öffnung auf der Oberseite des Halbleiterkörpers überdeckt. Die Platte lässt sich vorzugsweise als diffusionsoffene Platte ausbilden. Es ist bevorzugt hierzu eine dünne Teflonschicht auszubilden. In einer alternativen Ausführungsform ist die Platte als opake Platte ausgebildet. Es ist auch bevorzugt, den Wall als eine Wallstruktur auszubilden. Hierbei werden mehrere Wälle mit mehreren separaten oder auch zusammenhängenden Teilen zur Ausbildung einer einzelnen größeren Öffnung oder mehreren getrennten Öffnungen auf der Oberfläche des Halbleiterkörpers ausgebildet. Insbesondere bei der Ausbildung von mehreren unterschiedlichen Sensoren auf einem einzigen Halbleiterkörper lassen sich hierdurch die Sensoren mit Platten abdecken, die an die Sensorart angepasste physikalische Eigenschaften aufweisen. In einer Ausführungsform lässt sich in einem Prozessschritt der Wall auf der Oberfläche des Halbleiterkörpers fixieren und in einem nachfolgenden Prozessschritt die Platte auf die Deckfläche auflegen. In einer alternativen Ausführungsform wird die Platte bereits vor dem Fixieren des Walls auf der Halbleiteroberfläche mit der Deckfläche des Walls verbunden. Erst nachdem die Platte auf der Deckfläche aufliegt findet der Moldprozess statt. Mittels der aufliegenden Platte sind die in der Öffnung befindlichen Bauteile, insbesondere Sensoren, zuverlässig vor Verunreinigung auch beim Molden geschützt. Es sei angemerkt, dass sich der Sensor als FET Sensor, vorzugsweise als Gassensor, aufweisend ein Halbleitersubstrat und ein suspended Gate, ausbilden lässt.

Gemäß einer Weiterbildung ist es bevorzugt, zwischen der Deckfläche und der Platte eine umlaufende streifenförmige Klebeschicht auszubilden. Mit der Klebeschicht, die vorzugsweise als eine streifenförmige Klebeschicht oder als eine Trägerschicht mit einer doppelseitig klebenden Eigenschaften ausgebildet ist, lässt sich die Platte gegen ein Verrutschen in den weiteren Prozessschritten sichern. Des Weiteren wird eine zuverlässige Dichtfläche zwischen der Deckfläche des Walls und der Platte bei der Ausbildung des Halbleitergehäuses hergestellt. Hiernach wird der Wall mit der aufliegenden Platte auf die Oberfläche des Halbleiterkörpers vor der Durchführung des Moldprozesses aufgebracht. Bei dem anschließenden Moldprozess drückt ein Stempel mittels der gegebenen Auflagekraft vorzugsweise unmittelbar auf die Platte, und hierdurch auf die darunterliegende Deckfläche des Walls. Der Halbleiterkörper wird mit einer Kunststoffmasse vergossen. Ferner lassen sich bei Verwendung einer elastischen Klebeschicht die Druckkräfte des Stempels bei dem Moldprozess wenigstens teilweise aufzunehmen und eine Beschädigung der untenliegenden Halbleiteroberfläche reduzieren.

Es versteht sich, dass um eine moldmassefreie Öffnung zu erzielen, während des Molden wenigstens ein Teil der Deckfläche des Walls oder ein Teil der Platte formschlüssig von einem Teil der Oberfläche des Stempels abgeschlossen wird.

Gemäß einer Ausführungsform ist es bevorzugt, die Platte über die Außenseite des Walls mit einem Abstand überstehen zu lassen. Mit dem Überstand wird eine besonders zuverlässige Abdichtung für den innerhalb des Walls ausgebildeten Raum ausgebildet. Während des nachfolgenden Moldprozesses ist es bevorzugt, dass der Randbereich der Platte und die Außenseite des Walls eine formschlüssige Verbindung mit der Kunststoffmasse ausbilden. Indem die Kunststoffmasse bei einer überstehenden Platte sowohl an der Unterseite als auch auf der Oberseite der Platte einen Formschlussbereich erzeugt, wird eine besonders zuverlässige Abdichtung erzielt.

Untersuchungen der Anmelderin haben gezeigt, dass es besonders vorteilhaft ist, die Wälle nicht einzeln auf die Oberfläche eines Halbleiterkörpers zu positionieren, sondern die Wälle zusammenhängend in eine Gitterstruktur, gebildet aus einer Vielzahl von mittels den Stegen zusammenhängenden Wällen, vor dem Moldprozess auf die Oberflächen von Halbleiterkörpern zu fixieren. Hierbei wird die Größe der Gitterstruktur und Anzahl der Wälle an die Anzahl und Größe der Halbleiterkörper, welche vorzugsweise auf einem ebenfalls zusammenhängenden Array von Leadframes angeordnet sind, angepasst. Ein Vorteil ist, dass nunmehr nicht jeder einzelne Wall auf die Oberfläche justiert werden muss, sondern nach der Justage der Gitterstruktur zu dem Leadframe Array, die Gitterstruktur in einem nachfolgenden Prozessschritt auf das Array aus Halbleiterkörpern aufgebracht wird.

In einer Weiterbildung werden vor dem Aufbringen der Gitterstruktur auf den Halbleiterkörpern auf den Deckflächen der Wälle die Platten angeordnet. Erst hiernach wird die Gitterstruktur auf den Halbleiterkörpern fixiert. Nach dem Moldprozess werden die Stege zwischen benachbarten Wällen durchtrennt und eine Vereinzelung der Wälle durchgeführt.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: einen schematischen Querschnitt einer Ausführungsform eines Halbleitergehäuses,
- Figur 2a: einen vergrößerten Ausschnitt des Walls auf der Oberseite des Halbleiterkörpers der Figur 1 in einer ersten Ausführungsform,
- Figur 2b: einen vergrößerten Ausschnitt des Walls auf der Oberseite des Halbleiterkörpers der Figur 1 in einer zweiten Ausführungsform,
- Figur 3: eine perspektivische Ansicht einer rahmenförmigen Ausprägung eines Walls auf der Halbleiteroberfläche in einem ungemoldeten Zustand,
- Figur 4: einen schematischen Querschnitt einer Ausführungsform eines Halbleitergehäuses mit aufliegender Platte,
- Figur 5a: einen vergrößerten Ausschnitt des Walls auf der Oberseite des Halbleiterkörpers der Figur 1 mit aufliegender Platte welche gegen die Außenkante des Walls zurückgesetzt ist,
- Figur 5b: einen vergrößerten Ausschnitt des Walls auf der Oberseite des Halbleiterkörpers der Figur 1 mit aufliegender Platte welche über die Außenkante des Walls übersteht,
- Figur 6: eine perspektivische Ansicht einer rahmenförmigen Ausprägung eines Walls mit aufliegender Platte in einem ungemoldeten Zustand,
- Figur 7: eine perspektivische Ansicht des Träger der Figur 6 in einem vergossen Zustand als QFN Gehäuse.

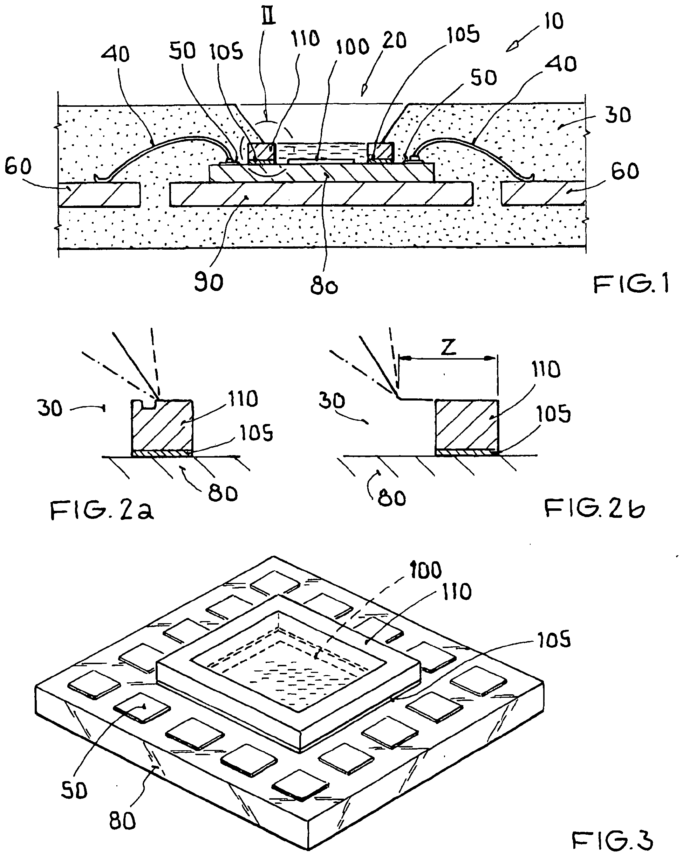

Die Abbildung der Figur 1 zeigt eine Ausführungsform eines erfindungsgemäßen Halbleitergehäuses 10, mit einer Öffnung 20, einer Kunststoffmasse 30, welche Bonddrähte 40, die Metallflächen 50 mit Pins 60 elektrisch verbinden, umschließt. Des Weiteren umschließt die Kunststoffmasse 30, die aus einem ersten Kunststoffmaterial besteht, einen Teil einer Oberfläche eines Halbleiterkörpers 80. Der Halbleiterkörper 80 ist auf einem Metallträger 90 angeordnet und mit dem Metallträger 90 kraftschlüssig verbunden. In der Öffnung 20 ist ein schematisch dargestellter Sensor 100 angeordnet. Es sei angemerkt, dass sich der Sensor als FET Sensor, vorzugsweise als Gassensor, aufweisend ein Halbleitersubstrat und ein suspended Gate, ausbilden lässt. Die Kunststoffmasse 30 beginnt im Bereich der unteren Seite der Öffnung 20 auf einem Wall 110 der als Rahmen ausgebildet ist. Der Rahmen weist einen rechteckigen Querschnitt auf. An der Unterseite des Rahmens ist eine Fixierschicht 105 ausgebildet. Zwar zeigt das dargestellte Gehäuse eine QFN Gehäuseform, jedoch lassen sich auch andere Gehäuseformen mit der erfindungsgemäßen Rahmenkonstruktion für die Erzeugung einer Öffnung verwenden.

In der Abbildung der Figur 2a ist ein Ausschnitt des Übergangs zwischen der Kunststoffmasse 30 im Bereich des Walls 110 als Querschnitt vergrößert dargestellt. Die Kunststoffmasse 30 bildet mit der Deckfläche des Rahmens 110, je nach rücklaufendem Profil des Stempels beim Molden unterschiedliche Steigungswinkel aus. Die Fixierschicht 105 ist an der Unterseite des Walls 110 auf der ganzen Fläche ausgebildet.
In der Abbildung der Figur 2b ist ebenfalls ein Ausschnitt des Übergangs zwischen der Kunststoffmasse 30 im Bereich des Walls 110 als Querschnitt vergrößert dargestellt. Im Unterschied zu der Ausführungsform der Figur 2a zeigt der Beginn der Moldmasse einen Versatz z zu der Innenkante des Walls 110, d.h. der Stempel weist im Vergleich zu der Figur 2a eine größere Auflagefläche auf die Deckfläche des Walls 110 auf.

In der Abbildung der Figur 3 ist eine perspektivische Ansicht des Walls 110 auf dem Halbleiterkörper 80 nach Abschluss des Klebeprozesses dargestellt. Der Wall 110 weist eine rahmenförmige Ausprägung auf der Oberfläche des Halbleiterkörpers 120 auf. Die Positionierung und Größe des Rahmens wird insbesondere von der Größe der Lage der Sensorfläche bestimmt.

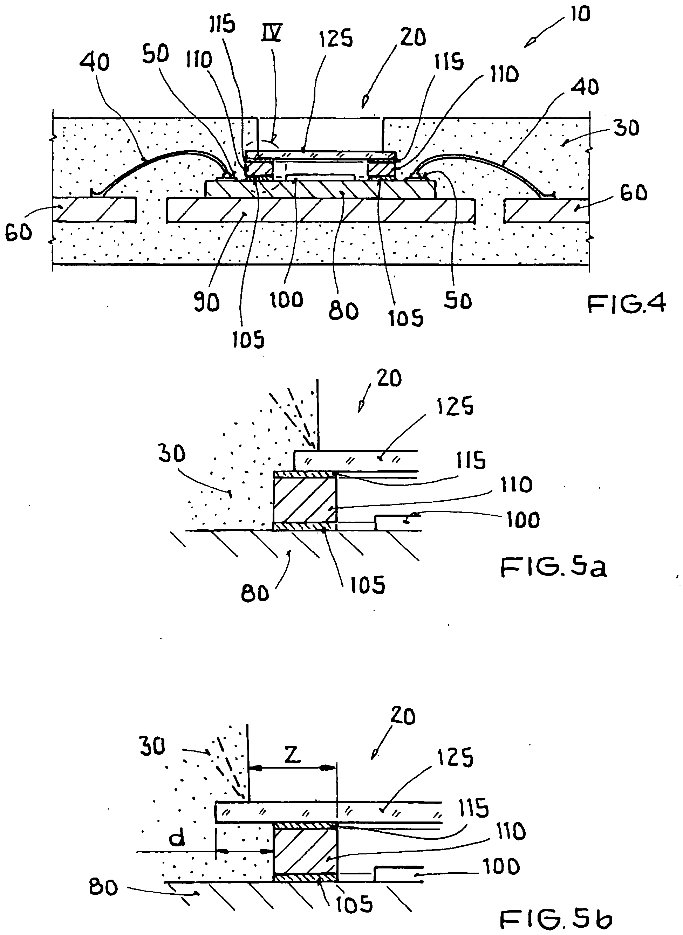

In der Abbildung der Figur 4 ist auf der Deckfläche des Walls 110 eine Klebstoffschicht 115 vollflächig ausgebildet. Auf der Klebstoffschicht 115 ist eine Platte 125 ausbildet. Die Platte 125 überdeckt die innerhalb des Walls 110 liegende Fläche vollständig und ist mittels der Höhe des Walls 110 und der Dicke der beiden Schichten 105, 115 von der Oberfläche des Halbleiterkörpers beabstandet.

In der Abbildung der Figur 5a ist ein Ausschnitt des Übergangs zwischen der Kunststoffmasse 30 im Bereich des Walls 110 als Querschnitt vergrößert dargestellt. Die Deckfläche des Walls 110 weist die Klebstoffschicht 115 und die aufliegende Platte 125 auf, wobei das Ende der Platte 125 gegenüber der Außenseite des Walls 110 zurückversetzt ist. Die Kunststoffmasse 30 bildet mit der Deckfläche des Walls 110 und der Oberseite der Platte 125 in deren Randbereich eine formschlüssige Verbindung aus. Je nach rücklaufendem Profil des Stempels beim Molden, bildet die Öffnung 20 unterschiedliche Steigungswinkel aus.
In der Abbildung der Figur 5b ist ebenfalls ein Ausschnitt des Übergangs zwischen der Kunststoffmasse 30 Im Bereich des Walls 110 als Querschnitt vergrößert dargestellt. Hierbei steht die Platte 125 um einen Abstand d über die Außenkante des Walls 110 über. Im Unterschied zu der Ausführungsform der Figur 5a zeigt der Beginn der Moldmasse einen Versatz z zu der Innenkante des Walls 110, d.h. der Stempel weist im Vergleich zu der Figur 5a eine größere Auflagefläche auf die Deckfläche des Walls 110 auf. Es sei angemerkt, dass in einer alternativen Ausführungsform der Versatz z auch wesentlich geringer, als in der Figur 5b dargestellt ist, ausbilden lässt. Hierbei bedeckt die Moldmasse die Platte 125 derart, dass sich ein Teil der Moldmasse oberhalb der Deckfläche befindet. Die Kunststoffmasse 30 umschließt durch den Überstand der Platte 125 sowohl an der Oberseite als auch an der Unterseite. Hierdurch wird eine besonders gute Abdichtung und oder Fixierung der Platte und insbesondere eine kraftschlüssige Verbindung der Platte mit dem Wall und der Halbleiteroberfläche erreicht.

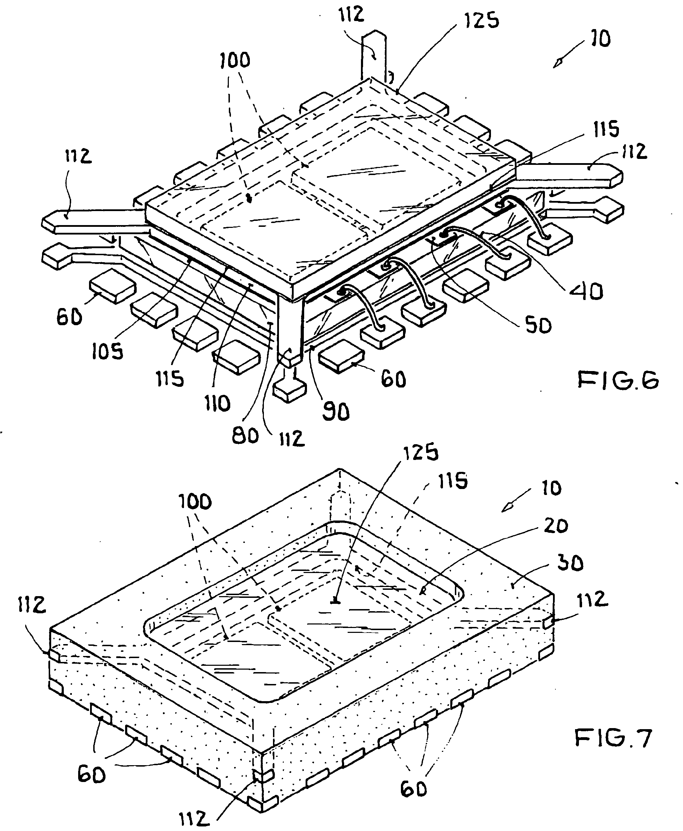

In der Abbildung der Figur 6 ist eine perspektivische Ansicht des Walls 110 mit aufliegender Platte 125 auf dem Halbleiterkörper 80 nach Abschluss der Fixierung und vor dem Molden dargestellt. Der Wall 110 weist eine rahmenförmige Ausprägung auf der Oberfläche des Halbleiterkörpers 120 auf und ist vollständig von der Platte 125 überdeckt. An allen vier Ecken des Walls 110 sind Stege 112 ausgebildet. Es sei angemerkt, dass unterhalb der Stege keine Metallflächen zum Bonden ausgebildet sind. Die Bonddrähte 40 sind wegen der Übersichtlichkeit nicht dargestellt. Die Stege 112 bilden Verbindungen zu einem oder mehreren benachbarten nicht dargestellten Wällen aus und sind Teil einer nicht dargesteliten Gitterstruktur. Die Stege werden mit der Kunststoffmasse 30 eingegossen und in einem nach dem Molden durchgeführten Vereinzelungsprozess durchtrennt.

In der Abbildung der Figur 7 ist ein Halbleitergehäuse 10 ausgebildet als QFN-Gehäuse nach dem Vereinzeln in einer perspektivischen Ansicht dargestellt. An den Außenecken des Halbleitergehäuses 10 sind die Enden der durchtrennten Stege 112 sichtbar. In der Öffnung 20 ist die Oberseite einer Platte 125 sichtbar.

## Patentansprüche

1. Halbleitergehäuse (10) aufweisend,
- einen Metallträger (90)
- einen auf dem Metallträger (90) angeordneten Halbleiterkörper (80) mit einer Oberseite und einer Unterseite, wobei die Unterseite mit dem Metallträger (90) kraftschlüssig verbunden ist,
- wobei der Halbleiterkörper (80) auf der Oberseite mehrere Metallflä-chen (50) aufweist, und die Metallflächen (50) zur elektrischen Kon-taktierung des Halbleiterkörpers (80) mittels Bonddrähte (40) mit Pins (60) verbunden sind,
- eine Kunststoffmasse (30), wobei die Kunststoffmasse (30) die Bonddrähte (40) vollständig und den Halbleiterkörper (80) an dessen Oberseite sowie die Pins (60) teilweise umschließt, und wobei die Kunststoffmasse (30) an der Oberseite des Halbleiterkörpers (80) eine Öffnung (20) aufweist,
- einen rahmenförmigen oder ringförmigen Wall (110) auf der Oberseite des Halbleiterkörpers (80), wobei der Wall eine Deckfläche und eine von den Rändern des Halbleiterkörpers beanstandete Grundfläche aufweist und die lichten Innenmaße des Walls (110) die Größe der Öffnung (20) auf der Oberseite des Halbleiterkörpers (80) bestimmt,
wobei in Richtung des Normalenvektors der Fläche auf der Oberseite des Halbleiterkörpers (80) die Kunststoffmasse (30) im Bereich außerhalb der Öffnung (20) eine größere Höhe als der Wall (110) aufweist, **dadurch gekennzeichnet, dass**
auf der Deckfläche des Walls (110) eine Platte (125) ausgebildet ist, und die Platte (125) die Öffnung (20) auf der Oberseite des Halbleiterkörpers (80) überdeckt, und
der Randbereich der Platte und die Außenseite des Walls eine form-schlüssige Verbindung mit der Kunststoffmasse ausbilden, und zwischen der Grundfläche des Walls (110) und der Oberseite des Halbleiterkörpers (80) eine Fixierschicht (105) ausgebildet ist und der Wall (110) von einer innerhalb der Öffnung (20) ausgebildeten Sensorfläche beabstandet ist und der Wall (110) an wenigstens einer Außenseite einen Steg (112) aufweist.

2. Halbleitergehäuse (10) nach Anspruch 1, **dadurch gekennzeichnet, dass** die Fixierschicht (105) als ein umlaufend geschlossener Streifen ausgebildet ist.

3. Halbleitergehäuse (10) nach Anspruch 1 oder 2, **dadurch gekennzeichnet, dass** der Wall (110) an wenigstens einer Außenseite einen Steg (112) aufweist.

4. Halbleitergehäuse (10) nach Anspruch 3, **dadurch gekennzeichnet, dass** der Steg (112) an der Außenseite des Halbleitergehäuses (80) teilweise sichtbar ist.

5. Halbleitergehäuse (10) nach Anspruch 3 oder 4, **dadurch gekennzeichnet, dass** der Wall (110) genau vier Stege (112) aufweist.

6. Halbleitergehäuse (10) nach einem der Ansprüche 1 bis 5, **dadurch gekennzeichnet, dass** der Wall (110) aus Metall ausgebildet ist und das Metall vorzugsweise Kupfer enthält.

7. Halbleitergehäuse (10) nach einem der Ansprüche 1 bis 6, **dadurch gekennzeichnet, dass** der Wall (110) einen im Wesentlichen rechteckigen Querschnitt und eine Höhe im Bereich von mindestens 100 µm bis maximal 1 mm aufweist.

8. Halbleitergehäuse (10) nach einem der Ansprüche 1 bis 7, **dadurch gekennzeichnet, dass** die Außenseiten des Walls (110) von dem Rand des Halbleiterkörpers (80) beabstandet sind.

9. Halbleitergehäuse (10) nach einem der Ansprüche 1 bis 8, **dadurch gekennzeichnet, dass** die Kunststoffmasse (30) und Deckfläche des Walls (110) einen Absatz ausbilden, so dass wenigstens ein Teil der Deckfläche des Walls (110) nicht mit der Kunststoffmasse (30) bedeckt ist.

10. Halbleitergehäuse (10) nach einem der Ansprüche 1 bis 9, **dadurch gekennzeichnet, dass** auf der Deckfläche des Walls (110) eine Platte (125) ausgebildet ist, und die Platte (125) die Öffnung (20) auf der Oberseite des Halbleiterkörpers (80) überdeckt.

11. Halbleitergehäuse (10) nach einem der Ansprüche 1 bis 10, **dadurch gekennzeichnet, dass** zwischen der Deckfläche des Walls (110) und der Platte (125) eine umlaufende streifenförmige Klebeschicht (115) ausgebildet ist.

12. Halbleitergehäuse (10) nach einem der Ansprüche 1 bis 11, **dadurch gekennzeichnet, dass** die Platte (125) über die Außenseite des Walls (110) mit einem Abstand (d) übersteht.

13. Halbleitergehäuse (10) nach einem der Ansprüche 1 bis 12, **dadurch gekennzeichnet, dass** der Randbereich der Platte (125) und die Außenseite des Walls (110) eine formschlüssige Verbindung mit der Kunststoffmasse (30) aufweist.

14. Halbleitergehäuse (10) nach einem der Ansprüche 1 bis 13, **dadurch gekennzeichnet, dass** der Winkel der Öffnung gegenüber der Normalen der Oberfläche des Halbleiterkörpers größer 0°, vorzugsweise 7° bis 10° beträgt.

15. Verfahren zur Herstellung eines Halbleitergehäuses (10) nach Anspruch 1 mit einer Öffnung (20), wobei
in einem Prozessschritt ein Wafer in Halbleiterkörper (80) vereinzelt wird,
der Halbleiterkörper (80), der eine Oberseite und eine Unterseite aufweist, mit seiner Unterseite auf einen Metallträger (90) befestigt wird,
der Halbleiterkörper (80) mit Pins (60) in einem Bondprozess über Bonddrähte (40) elektrisch verbunden wird,
**dadurch gekennzeichnet, dass**
in einem nachfolgenden Prozessschritt ein rahmenförmiger Wall (110) auf der Oberfläche des Halbleiterkörper (80) fixiert wird, und in einem anschließenden Moldprozess ein Stempel, der eine Oberfläche aufweist, und die Oberfläche des Stempels wenigstens teilweise auf die Deckfläche des Walls (110) gedrückt wird und anschließend eine Kunststoffmasse (30) eingespritzt und ausgehärtet wird, so dass die Bonddrähte (40) vollständig und der Halbleiterkörper (80) auf dessen Oberfläche sowie die Pins (60) teilweise von der Kunststoffmasse (30) umschlossen werden.

16. Verfahren nach Anspruch 15, **dadurch gekennzeichnet, dass** auf einer Klebeschicht auf der Deckfläche des Walls (110) eine Platte (125) vor der Durchführung des Moldprozesses angeordnet wird.

17. Verfahren nach Anspruch 15, **dadurch gekennzeichnet, dass** auf der gesamten Länge des Walls (110) wenigstens ein Teil der Deckfläche des Walls (110) oder ein Teil der Platte (125) formschlüssig von einem Teil der Oberfläche des Stempels abgeschlossen wird.

18. Verfahren nach einem der Ansprüche 15 bis 16, **dadurch gekennzeichnet, dass** während des Moldprozesses die Oberfläche des Stempels unmittelbar auf die Deckfläche des Walls (110) oder auf die Oberfläche der Platte (125) gedrückt wird.

19. Verfahren nach einem der Ansprüche 15 bis 17, **dadurch gekennzeichnet, dass** eine Gitterstruktur, gebildet aus einer Vielzahl von mittels Stegen (112) zusammenhängenden Wällen, vor dem Moldprozess auf den Oberflächen von Halbleiterkörpern fixiert wird.

20. Verfahren nach Anspruch 19, **dadurch gekennzeichnet, dass** vor dem Fixieren der Gitterstruktur auf den Deckflächen der Wälle Platten, die vorzugsweise Teflon enthalten, angeordnet werden.

21. Verfahren nach Anspruch 19 oder Anspruch 20, **dadurch gekennzeichnet, dass** nach dem Moldprozess die Stege (112) zwischen benachbarten Wällen durchtrennt werden und eine Vereinzelung der Wälle durchgeführt wird.

22. Verwendung des Halbleitergehäuses (10) nach einem der vorstehenden Ansprüche zur Aufnahme eines Sensors (100), insbesondere eines Gassensors in der Öffnung (20) des Halbleitergehäuses (10).

## Claims

1. Semiconductor housing (10) comprising:
- a metal support (90),
- a semiconductor body (80), which is arranged on the metal support (90), with an upper side and a lower side, wherein the lower side is connected with the metal support (90) by friction couple,
- wherein the semiconductor body (80) has several metal surfaces (50) on the upper side and the metal surfaces (50) are connected by means of bond wires (40) with pins (60) for electrical contacting-making with the semiconductor body (80),
- a synthetic material mass (30), wherein the synthetic material mass (30) completely surrounds the bond wires (40) and partly surrounds the semiconductor body (80) at the upper side thereof as well as the pins (60) and wherein the synthetic material mass (30) has an opening (20) at the upper side of the semiconductor body (80), and
- a frame-shaped or annular wall (110) on the upper side of the semiconductor body (80), wherein the wall has a top surface and a base surface, which is spaced from the edges of the semiconductor body, and the clear internal dimension of the wall (110) determines the size of the opening (20) on the upper side of the semiconductor body (80) and wherein in the direction of the normal vector of the surface on the upper side of the semiconductor body (80) the synthetic material mass (30) has in the region outside the opening (20) a greater height than the wall (110),
**characterised in that**
a plate (125) is formed on the top surface of the wall (110) and covers the opening (20) on the upper side of the semiconductor body (80),
the edge region of the plate and the outer side of the wall form a mechanically positive connection with the plastics material mass,
a fixing layer (105) is formed between the base surface of the wall (110) and the upper side of the semiconductor body (80),
the wall (110) is spaced from a sensor surface formed within the opening (20) and
the wall (11) has a web (112) at at least one outer side.

2. Semiconductor housing (10) according to claim 1, **characterised in that** the fixing layer (105) is formed as an encircling closed strip.

3. Semiconductor housing (10) according to claim 1 or 2, **characterised in that** the wall (110) has a web (112) at at least one outer side.

4. Semiconductor housing (10) according to claim 3, **characterised in that** the web (112) is partly visible at the outer side of the semiconductor housing (80).

5. Semiconductor housing (10) according to claim 3 or 4, **characterised in that** the wall (110) has exactly four webs (112).

6. Semiconductor housing (10) according to any one of claims 1 to 5, **characterised in that** the wall (110) is made of metal and the metal preferably contains copper.

7. Semiconductor housing (10) according to any one of claims 1 to 6, **characterised in that** the wall (110) has a substantially right-angled cross-section and a height in the range of at least 100 microns to at most 1 millimetre.

8. Semiconductor housing (10) according to any one of claims 1 to 7, **characterised in that** the outer sides of the wall (110) are spaced from the edge of the semiconductor body (80).

9. Semiconductor housing (10) according to any one of claims 1 to 8, **characterised in that** the synthetic material mass (30) and the top surface of the wall (110) form a step so that at least a part of the top surface of the wall (110) is not covered by the synthetic material mass (30).

10. Semiconductor housing (10) according to any one of claims 1 to 9, **characterised in that** a plate (125) is formed on the top surface of the wall (110) and covers the opening (20) on the upper side of the semiconductor body (80).

11. Semiconductor housing (10) according to any one of claims 1 to 10, **characterised in that** an encircling strip-shaped adhesive layer (115) is formed between the top surface of the wall (110) and the plate (125).

12. Semiconductor housing (10) according to any one of claims 1 to 11, **characterised in that** the plate (125) protrudes by a distance (d) beyond the outer side of the wall (110).

13. Semiconductor housing (10) according to any one of claims 1 to 12, **characterised in that** the edge region of the plate (125) and the outer side of the wall (110) have a mechanically positive connection with the synthetic material mass (30).

14. Semiconductor housing (10) according to any one of claims 1 to 13, **characterised in that** the angle of the opening relative to the normal of the surface of the semiconductor body is greater than 0°, preferably is 7° to 10°.

15. Method of producing a semiconductor housing (10) according to claim 1, with an opening (20), wherein
in a process step a wafer is isolated in the semiconductor body (80),
the semiconductor body (80), which has an upper side and a lower side, is attached by its lower side to a metal support (90) and
the semiconductor body (80) is electrically connected with pins (60) by way of bond wires (40) in a bonding process,
characterised that
in a subsequent process step a frame-shaped wall (110) is fixed onto the surface of the semiconductor body (80),
in a subsequent moulding process with a die, which has a surface, the surface of the die is pressed at least partly onto the top surface of the wall (110) and
subsequently a synthetic material mass (30) is injected and hardened so that the bond wires (40) are completely enclosed by the synthetic material mass (30) and the semiconductor body (80) on the surface thereof as well as the pins (60) are partly enclosed by the synthetic material mass (30).

16. Method according to claim 15, **characterised in that** a plate (125) is arranged on an adhesive layer on the top surface of the wall (110) before carrying out the moulding process.

17. Method according to claim 15, **characterised in that** at least a part of the top surface of the wall (110) or part of the plate (125) is mechanically positively closed off by a part of the surface of the die over the entire length of the wall (110).

18. Method according to one of claims 15 and 16, **characterised in that** during the moulding process the surface of the die is pressed directly onto the top surface of the wall (110) or onto the surface of the plate (125).

19. Method according to any one of claims 15 to 17, **characterised in that** a grid structure formed from a plurality of walls cohering by means of webs (112) is fixed onto the surfaces of semiconductor bodies before the moulding process.

20. Method according to claim 19, **characterised in that** plates preferably containing 'Teflon' are arranged before fixing of the grid structure onto the top surfaces of the walls.

21. Method according to claim 19 or claim 20, **characterised in that** after the moulding process the webs (112) are cut through between adjacent walls and a separation of the walls is carried out.

22. Use of the semiconductor housing (10) according to any one of the preceding claims for mounting a sensor (100), particularly a gas sensor, in the opening (20) of the semiconductor housing (10).

## Revendications

1. Boîtier semi-conducteur (10) présentant
- un support métallique (90),
- un corps semi-conducteur (80) disposé sur le support métallique (90), avec un côté supérieur et un côté inférieur, dans lequel le côté inférieur est assemblé par adhérence au support métallique (90),
- dans lequel le corps semi-conducteur (80) présente plusieurs faces métalliques (50) sur le côté supérieur et les faces métalliques (50) sont reliées à des broches (60) au moyen de fils de liaison (40) pour le contact électrique avec le corps semi-conducteur (80),
- une masse de matière plastique (30), dans lequel la masse de matière plastique (30) enrobe entièrement les fils de liaison (40) et partiellement le corps semi-conducteur (80) sur son côté supérieur ainsi que les broches (60) et dans lequel la masse de matière plastique (30) présente une ouverture (20) sur le côté supérieur du corps semi-conducteur (80),
- un muret en forme de cadre ou d'anneau (110) sur le côté supérieur du corps semi-conducteur (80), dans lequel le muret présente une face de sommet et une face de base espacée des bords du corps semi-conducteur et les dimensions intérieures libres du muret (110) déterminent la grandeur de l'ouverture (20) sur le côté supérieur du corps semi-conducteur (80),
dans lequel la masse de matière plastique (30) présente dans la région située à l'extérieur de l'ouverture (20), dans la direction du vecteur normal à la face sur le côté supérieur du corps semi-conducteur (80), une plus grande hauteur que le muret (110),
**caractérisé en ce que**
une plaque (125) est formée sur la face de sommet du muret (110) et la plaque (125) recouvre l'ouverture (20) sur le côté supérieur du corps semi-conducteur (80) et
la région de bord de la plaque et le côté extérieur du muret forment un assemblage par emboîtement avec la masse de matière plastique et
une couche de fixation (105) est formée entre la face de base du muret (110) et le côté supérieur du corps semi-conducteur (80) et le muret (110) est espacé d'une face de détecteur formée à l'intérieur de l'ouverture (20) et le muret (110) présente une patte (112) sur au moins un côté extérieur.

2. Boîtier semi-conducteur (10) selon la revendication 1, **caractérisé en ce que** la couche de fixation (105) est réalisée sous la forme d'une bande périphérique fermée.

3. Boîtier semi-conducteur (10) selon la revendication 1 ou 2, **caractérisé en ce que** le muret (110) présente une patte (112) sur au moins un côté extérieur.

4. Boîtier semi-conducteur (10) selon la revendication 3, **caractérisé en ce que** la patte (112) est partiellement visible sur le côté extérieur du boîtier semi-conducteur (80).

5. Boîtier semi-conducteur (10) selon la revendication 3 ou 4, **caractérisé en ce que** le muret (110) présente exactement quatre pattes (112).

6. Boîtier semi-conducteur (10) selon l'une quelconque des revendications 1 à 5, **caractérisé en ce que** le muret (110) est réalisé en métal et le métal contient de préférence du cuivre.

7. Boîtier semi-conducteur (10) selon l'une quelconque des revendications 1 à 6, **caractérisé en ce que** le muret (110) présente une section transversale essentiellement rectangulaire et une hauteur dans la plage d'au moins 100 µm à 1 mm au maximum.

8. Boîtier semi-conducteur (10) selon l'une quelconque des revendications 1 à 7, **caractérisé en ce que** les côtés extérieurs du muret (110) sont espacés du bord du corps semi-conducteur (80).

9. Boîtier semi-conducteur (10) selon l'une quelconque des revendications 1 à 8, **caractérisé en ce que** la masse de matière plastique (30) et la face de sommet du muret (110) forment un retrait, de telle manière qu'au moins une partie de la face de sommet du muret (110) ne soit pas couverte avec la masse de matière plastique (30).

10. Boîtier semi-conducteur (10) selon l'une quelconque des revendications 1 à 9, **caractérisé en ce qu'**une plaque (125) est formée sur la face de sommet du muret (110) et la plaque (125) recouvre l'ouverture (20) sur le côté supérieur du corps semi-conducteur (80).

11. Boîtier semi-conducteur (10) selon l'une quelconque des revendications 1 à 10, **caractérisé en ce qu'**une couche de colle en forme de ligne périphérique (115) est formée entre la face de sommet du muret (110) et la plaque (125).

12. Boîtier semi-conducteur (10) selon l'une quelconque des revendications 1 à 11, **caractérisé en ce que** la plaque (125) déborde d'une distance (d) au-delà du côté extérieur du muret (110).

13. Boîtier semi-conducteur (10) selon l'une quelconque des revendications 1 à 12, **caractérisé en ce que** la région de bord de la plaque (125) et le côté extérieur du muret (110) présentent un assemblage par emboîtement avec la masse de matière plastique (30).

14. Boîtier semi-conducteur (10) selon l'une quelconque des revendications 1 à 13, **caractérisé en ce que** l'angle de l'ouverture par rapport à la normale à la surface du corps semi-conducteur est plus grand que 0°, et vaut de préférence de 7° à 10°.

15. Procédé de fabrication d'un boîtier semi-conducteur (10) selon la revendication 1 avec
une ouverture (20), dans lequel,
dans une étape de procédé, on sépare une galette en corps semi-conducteurs (80), on fixe le corps semi-conducteur (80), qui présente un côté supérieur et un côté inférieur, par son côté inférieur sur un support métallique (90),
on relie électriquement le corps semi-conducteur (80) à des broches (60) au moyen de fils de liaison (40) par un procédé de liaison,
**caractérisé en ce que**
dans une étape de procédé suivante, on fixe un muret en forme de cadre (110) sur la surface du corps semi-conducteur (80), et dans un procédé de moulage qui suit on presse un poinçon qui présente une surface et la surface du poinçon, au moins en partie sur la face de sommet du muret (110) et on injecte et on durcit ensuite une masse de matière plastique (30), de telle manière que l'on enrobe les fils de liaison (40) entièrement et le corps semi-conducteur (80) sur sa surface ainsi que les broches (60) partiellement avec la masse de matière plastique (30).

16. Procédé selon la revendication 15, **caractérisé en ce que** l'on dispose une plaque (125) sur une couche de colle sur la face de sommet du muret (110) avant l'exécution du procédé de moulage.

17. Procédé selon la revendication 15, **caractérisé en ce qu'**au moins une partie de la face de sommet du muret (110) ou une partie de la plaque (125) est terminée par emboîtement par une partie de la surface du poinçon sur toute la longueur du muret (110).

18. Procédé selon une des revendications 15 à 16, **caractérisé en ce que** la surface du poinçon est pressée directement sur la face de sommet du muret (110) ou sur la surface de la plaque (125) pendant le procédé de moulage.

19. Procédé selon l'une quelconque des revendications 15 à 17, **caractérisé en ce que** l'on fixe une structure de grille, formée par une multiplicité de murets reliés au moyen de pattes (112), sur les surfaces de corps semi-conducteurs avant le procédé de moulage.

20. Procédé selon la revendication 19, **caractérisé en ce que** l'on dispose des plaques, qui contiennent de préférence du Téflon, sur les faces de sommet des murets avant la fixation de la structure de grille.

21. Procédé selon la revendication 19 ou la revendication 20, **caractérisé en ce que** l'on coupe les pattes (112) entre des murets voisins après le procédé de moulage et on opère une séparation des murets.

22. Utilisation du boîtier semi-conducteur (10) selon l'une quelconque des revendications précédentes pour la réception d'un capteur (100), en particulier d'un détecteur de gaz dans l'ouverture (20) du boîtier semi-conducteur (10).
